# EUROPEAN PATENT APPLICATION

(11) **EP 1 659 635 A2**
(43) Date of publication of application: **24.05.2006**
(21) Application number: 05025087.7
(22) Date of filing: 17.11.2005
(51) Int. Cl.: H01L 29/78

(54) **Bidirectional MOS semiconductor device**

(30) Priority: 17.11.2004 JP 2004333225
(71) Applicant: SANYO ELECTRIC CO., LTD., Moriguchi-shi, Osaka 570-8677 (JP)
(72) Inventor: Yanagida , Masamichi, Ota-city, Gunma 373-0847 (JP); Mandai, Tadao, Ora-gun, Gunma 370-0524 (JP)
(74) Representative: Glawe, Delfs, Moll

(57) **Abstract**

In a preferred embodiment of the present invention, first MOS transistors (21) connected to first source electrodes (11) and second MOS transistors (22) connected to second source electrodes (12) are arranged alternately next to each other on one chip. Different potentials are applied respectively to the first source electrodes (11) and to the second source electrodes (12), and both of the MOS transistors (21, 22) are controlled with respect to an ON or Off state by one gate terminal. Currents flow along surroundings of trenches (4), whereby on-resistance is reduced.

## Description

### BACKGROUND OF THE INVENTION

### Field of the Invention

The present invention relates to a semiconductor device, and particularly to a semiconductor device realizing miniaturization of a switching element and reduction in on-resistance thereof, which is capable of switching a current path in two directions.

### Description of the Related Art

As a switching element, a switching element which not only switches a device between ON and OFF but also switches the direction of a current path (the direction in which a current flows) is also under development, and such a switching element is adopted, for example, to a protection circuit of a secondary battery.

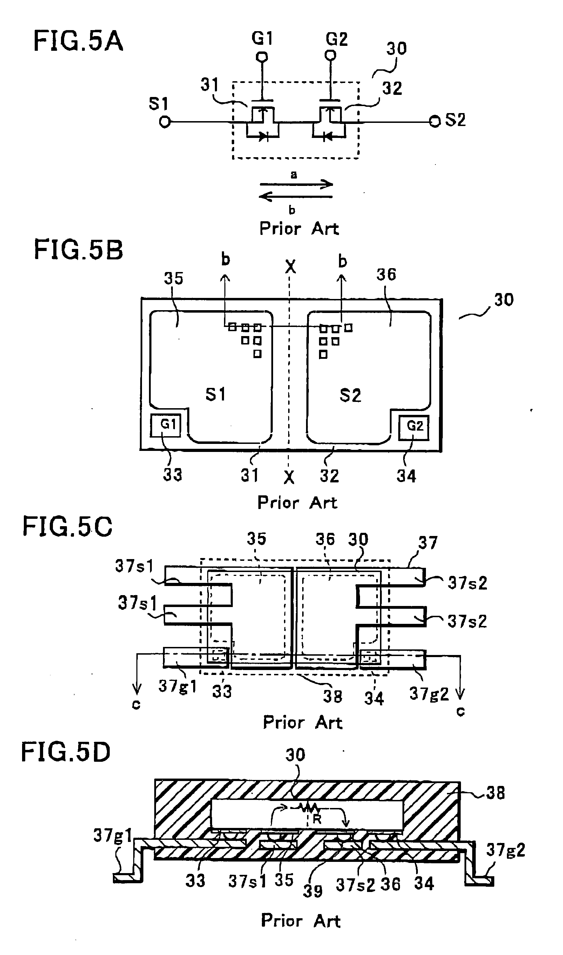

Figs. 5A to 5D show an example of a switching element which switches a current path in two directions.

Fig. 5A is a circuit diagram of the switching element. In a two-way switching element 30, first and second MOSFETs 31 and 32 are connected in series. Then, gate signals are respectively applied to gate terminals G1 and G2 of the respective MOSFETs to control both of the MOSFETs. Furthermore, a current path is switched in directions in accordance with a difference between a potential applied to a first source terminal S1 and a potential applied to a second source terminal S2.

The first and second MOSFETs 31 and 32 respectively have parasitic diodes. For example, according to control signals, the first MOSFET 31 is tuned OFF and the second MOSFET is turned ON. Additionally by allowing the first source terminal S1 to have a potential higher than that of the second source terminal S2, a current path is formed in a direction indicated by "a" by way of the second MOSFET 32 and the parasitic diode of the first MOSFET 31.

Furthermore, the switching elements such as the above described one are generally realized in such a way that two MOSFETs are integrated on one chip.

Fig. 5B is a plan view showing an example of the aforementioned semiconductor device 30.

The semiconductor device 30 is a device where the first and second MOSFETs 31 and 32 are integrated on one chip. The first MOSFET 31 includes: a first source electrode 35 connected to all of transistors of the first MOSFET 31; and a first gate pad electrode 33. The second MOSFET 32 similarly includes: a second source electrode 36, connected to all of transistors of the second MOSFET 32; and a second gate pad electrode 34.

A substrate (drain region) is common for the two MOSFETs. The first MOSFET 31 and the second MOSFET 32 are arranged, for example, symmetrical with respect to a center line X-X of the chip, and the first gate pad electrode 33 and the second gate pad electrode 34 are arranged respectively in corner portions on the chip, independently from the respective MOSFETs.

Figs. 5C and 5D are views showing a example of mounting of the aforementioned MOSFET 30. Fig. 5C is a plan view, and

Fig. 5D is a cross-sectional view taken along a line c-c in Fig. 5C.

As shown in the drawings, the chip 30 is mounted by means of a flip-chip method whereby the first source electrode 35 and the first gate pad electrode 33 face a lead frame 37 and the second source electrode 36 and the second gate pad electrode 34 face another lead frame 37.

That is, solder bumps 39 respectively connected to the first source electrode 35, the second source electrode 36, the first gate pad electrode 33 and the second gate pad electrode 34 are provided on a top surface of the chip. They are thus electrically connected to the lead frames 37 through the solder bumps 39. The MOSFET 30 and the lead frames 37 are covered with a resin layer 38 or the like, and source terminals 37s1 and 37s2, gate terminals 37g1 and 37g2 are lead out externally. This technology is described for instance in Japanese Patent Application Publication No. 2002-118258.

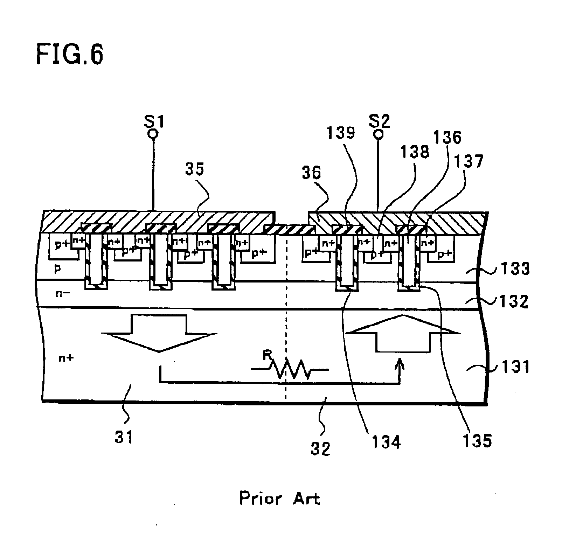

Fig. 6 shows a cross-sectional view taken along a line b-b of the MOSFET 30 in Fig. 5B. The MOSFETs 31 and 32, for example, are provided with an n(-)-type semiconductor layer 132 forming a drain region on an n(+)-type semiconductor substrate 131, and include a p-type channel layer 133 provided on the semiconductor layer 132. Trenches 134 are provided in the channel layer 133, and an gate electrode 136 is buried in each of the trenches 134 with a gate oxide film 135 interposed therebetween. An n(+)-type source region 137 is arranged next to each of the trenches 134, a p(+)-type body region 138 is arranged between each adjacent two of the source regions 137. A MOS transistor is formed in a region surrounded by adjacent ones of the trenches 134.

The first and second MOSFETs 31 and 32 are provided on the same semiconductor layer 131, that is, they have the drain region 132 in common. On the other hand, the source region 137 of the first MOSFET 31 is connected to the first source electrode 35 covering the first MOSFET 31, and the gate electrode 136 of the first MOSFET 31 is extended to the outside of the chip to be connected to the first gate pad electrode 33. Similarly, the source region 137 of the second MOSFET 32 is connected to the second source electrode 36 covering the first MOSFET 32, and the gate electrode 136 of the first MOSFET 32 is extended to the outside of the chip to be connected to the second gate pad electrode 34. (refer to Fig. 5)

For example, in accordance with a control signal applied to the gate electrode 136 (gate terminal), the first MOSFET 31 is tuned OFF and the second MOSFET 32 is turned ON, for example. At this time, by allowing the first source electrode 35 to have a potential higher than that of the second source electrode 36, a current path is formed as indicated by an arrow in Fig. 6. If the first source electrode 35 is allowed to have a potential lower than that of the second source electrode 36 provided that the first MOSFET 31 is tuned ON and the second MOSFET 32 is turned OFF, a current path in a direction reverse thereto is formed.

However, a current flows from one of the MOSFETs to the other by passing through the drain region 132 and the substrate 131. In other words, the current path has a long route, and thus resistance in the drain region becomes high. Flip-chip mounting as shown in Figs. 5C and 5D is what can at least reduce connection-resistance with external terminals as compared with mounting according to a wire-bonding method. The wire-bonding method is a method whereby a back surface of a chip is bonded to a lead frame, and the lead frame forming an external terminal is connected to a source electrode and a gate pad electrode by use of a bonding wire. However, the flip-chip mounting is affected by the resistance in the substrate, and thereby has a problem that reduction in on-resistance in a semiconductor device is hindered.

Additionally, in the case of the wire-bonding method, although the frame bonded at the drain side contributes to reduction in resistance, a current still flows toward the substrate, and a reduction in on-resistance has been limited because of the long current path. It is an object of this invention to provide an improved semiconductor device that suffers less under this drawback.

### SUMMARY OF THE INVENTION

The solution according to the invention lies in features of the independent claims and preferably in those of the dependent claims.

The invention provides a semiconductor device that includes a semiconductor layer operating as a drain region, a first metal-oxide-semiconductor transistor reaching the drain region and comprising a gate electrode and a source region that is formed above the drain region, a second metal-oxide-semiconductor transistor reaching the drain region and comprising a gate electrode and a source region that is formed above the drain region, a gate terminal connected with the gate of the first transistor and the gate of the second transistor, a first source terminal connected with the source region of the first transistor and receiving a first potential, and a second source terminal connected with the source region of the second transistor and receiving a second potential that is different from the first potential

The invention also provides a semiconductor device that includes a semiconductor substrate, a semiconductor layer disposed on the semiconductor substrate and operating as a drain region, a channel layer disposed on the semiconductor layer, and a plurality of first metal-oxide-semiconductor transistors and a plurality of second metal-oxide-semiconductor transistors. Each of the first and second transistors includes a trench penetrating the channel layer and reaching the semiconductor layer, a gate electrode disposed in the trench and a source region formed in the channel layer. Each of the first transistors is adjacent at least one of the second transistors, and the source regions of the first transistors are configured to receive a first potential and the source regions of the second transistors are configured to receive a second potential that is different from the first potential.

### BRIEF DESCRIPTION OF THE DRAWINGS

Figs. 1 is a schematic circuit diagram explaining a semiconductor device according to an preferred embodiment of the present invention.
Figs. 2A and 2B are respectively a plan view and a cross-sectional view explaining the semiconductor device according to the preferred embodiment of the invention.
Figs. 3A to 3C are plan views explaining the semiconductor device according to the preferred embodiment of the invention.
Fig. 4 is a circuit diagram showing an example of the semiconductor device according to the preferred embodiment of the invention.
Figs. 5A, 5B, 5C and 5D are respectively a circuit diagram, a plan view, a plan view and a cross-sectional view explaining a conventional semiconductor.
Fig. 6 is a cross-sectional view explaining the conventional semiconductor.

### DESCRIPTION OF THE PREFERRED EMBODIMENT

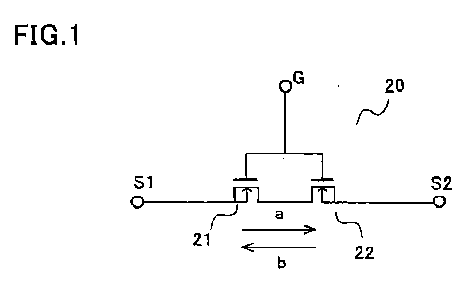

With reference to Figs. 1 to 4, a detailed description will be given of an embodiment of the present invention by taking an n-channel MOSFET as an example.

Fig. 1 is a schematic circuit diagram explaining a semiconductor device 20 according to the embodiment.

The semiconductor device 20 according to the embodiment is a MOSFET in which a plurality of MOS transistors 21 and a plurality of MOS transistors 22 are arranged on a substrate forming a drain region. The MOSFET 20 is connected to a gate terminal G and is controlled by a control signal applied to the gate terminal G. The gate terminal is only one.

The MOS transistors 21 and 22 are integrated on one chip, and terminals to be lead out externally are the gate terminal, a first and second source terminals S1 and S2. The drains for the MOS transistors 21 and 22 are common and connected to one another, whereby they are not lead out externally as drain terminals.

Different potentials are applied to the first and second source terminals S1 and S2. In the MOSFET 20, transistors connected to the first source terminal S1 are the first MOS transistors 21, and transistors connected to the second source terminal S2 are the second MOS transistors 22.

Gate electrodes respectively of the first and second MOS transistors 21 and 22 are connected to the gate terminal G, and ON or OFF states taken by the first and second MOS transistor 21 and 22 are concurrently switched in accordance with an control signal applied to the gate terminal G.

That is, the first MOS transistors 21 and the second MOS transistors 22 are turned ON concurrently. Additionally, if the first source terminal S1 has a potential higher than that of the second source terminal S2, a current flows in a direction indicated by an arrow "a". On the other hand, if a relation between the potentials is opposite to the above relation, a current flows in a direction indicated by an arrow "b".

Each cell of the first and second MOS transistors 21 and 22 is alternately arranged to each other on the same substrate.

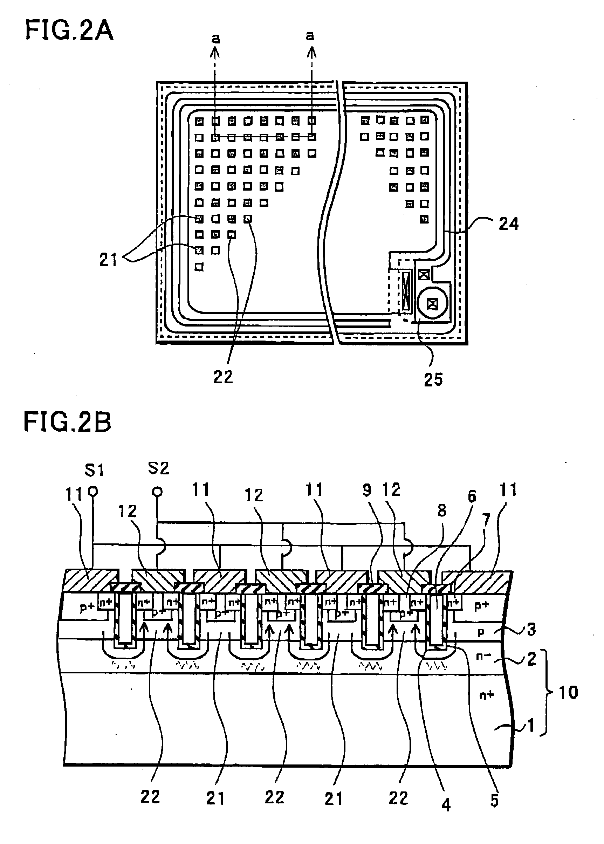

With reference to Figs. 2A and 2B, a more detailed description will be given. Figs. 2A is a plan view of the MOSFET 20 of the embodiment, and Fig. 2B is a cross-sectional view taken along a line a-a in Fig. 2A. Note that a metal layer constituting a source electrode is omitted.

A substrate 10 ( a drain region ) includes an n(+)-type semiconductor substrate 1 and an n(-)-type semiconductor layer provided thereon, and a p-type channel layer 3 is provided in the top surface of the substrate 10. Trench 4 reaching the n(-)-type semiconductor layer 2 (the drain region) from the top surface of the channel layer 3 is provided, and inner wall of the trench 4 is covered with gate oxide film 5. Thereafter, gate electrode 6 is provided by burying a conductive material such as polysilicon in the trench 4.

In the top surface of the channel layer 3 next to the trench 4, an n(+)-type source region 7 is formed, and a p(+)-type body region 8 is arranged in the top surface of the channel layer 3 between each adjacent two of the source regions 7. Thus, in regions surrounded by plurality of the trenches 4 which are patterned in a grid-like arrangement on the top surface of the substrate 10, a first MOS transistor 21 and a second MOS transistor 22 are arranged. In Fig. 2A, each of the transistors is indicated by a quadrangular.

At least top surfaces of the gate electrode 6 is covered with interlayer dielectric film 9, and the source region 7 and the body region 8 are exposed. Furthermore, the source region 7 and the body region 8 of the first MOS transistor 21 are contacted by a first source electrode 11. Similarly, the source region 7 and the body region 8 of the second MOS transistor 22 are contacted by a second source electrode 12.

The first source electrode 11 is connected to the first source terminal S1, and the second source electrode 12 is connected to the second source terminal S2. Different potentials are applied respectively to the first source terminal S1 and to the second source terminal S2.

In Fig. 2A, each hatched region is the MOS transistor 21 and each entirely white region is the MOS transistor 22. Thus, the MOS transistors 21 and 22 are alternately arranged adjacently to each other.

The gate electrodes 6 of the first and second MOS transistor 21 and 22 are extended out to a peripheral portion of the chip to be connected to a gate pad electrode 25 through a gate connection electrode 24. That is, a control signal applied to the gate terminal G is applied to each of the gate electrodes 6 of the first and second MOS transistor through the gate pad electrode.

The gate pad electrode 25 is only one as shown in Fig. 2A, and the plurality of first MOS transistors 21 and the plurality of second MOS transistors 22 are concurrently turned ON or concurrently turned OFF in accordance with the control signal. In a state where both of the first and second MOS transistors are ON, channel regions (not illustrated) are formed in the channel layer 3 along all of the trenches 4.

In this embodiment, different source potentials are applied respectively to the plurality of first MOS transistors 21 and to the plurality of second MOS transistors 22 adjacent thereto. Consequently, when these transistors are ON, current paths are formed, as indicated by arrows, along side walls and bottoms of the trenches 4, and a current flows between each adjacent the first MOS transistor 21 and the second transistor 22.

For example, in a case where the first source terminal S1 has a potential higher than that of the second source terminal S2, the current paths from the first MOS transistors 21 toward the second MOS transistors 22 adjacent thereto (indicated by arrows) are formed. On the other hand, in a case where a relation between the potentials is opposite to the above relation, the current paths in directions reverse to the respective arrows, from the second MOS transistors 22 toward the first MOS transistors 21 adjacent thereto, are formed.

Therefore, it is possible to cause a current to flow between the first and second MOS transistors 21 and 22 adjacent thereto without especially making the current to bypass the n(+)-type semiconductor layer 1. A length of the current path formed around each of the trench 4 is not more than 5 µm. That is, a resistance is reduced as compared to the case where the semiconductor substrate 1 is included in the current path, the substrate 1 having a length of several tens to several hundreds µm although being heavily doped with an impurity.

Furthermore, the chip is mounted by using of a wire bonding method whereby the first source electrode 11, the second source electrode 12 and the gate pad electrode 25 are connected to a lead frame or the like by bonding a bonding wire to them through thermocompression bonding, or by using of a known method such as a flip-chip method shown in Figs. 5C and 5D.

Accordingly, in the case where the chip is mounted by using of, for example, the flip-chip method, this embodiment can contribute to a reduction in on-resistance in the device by considerably reducing the resistance in the drain region.

Moreover, it is sufficient to have the only one gate pad electrode 25. Therefore, an area of the one gate pad electrode can be reduced to a half the occupied area conventionally needed for the gate pad electrodes 33 and 34 (in Fig. 5B). Accordingly, a cell density can be enhanced for the same size of chips, and on-resistance of the device is also reduced thereby.

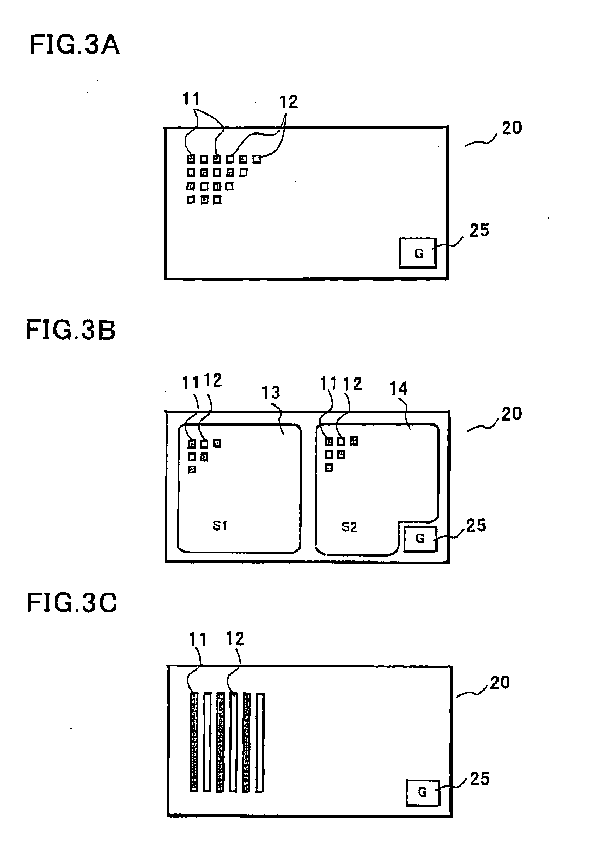

Figs. 3A to 3C are plan views explaining outlines of the first source electrode 11 and the second source electrode 12 of this embodiment. In each of Figs. 3A to 3C, a plurality of regions indicated by the same quadrangular outline are the source electrodes, and the first and second source electrode 11 and 12 are indicated respectively by a hatched region and by an entirely white region. Note here that Figs. 3A and 3B correspond to a case where the trenches 4 are patterned in a grid-like arrangement on the top surface of the substrate.

As shown in Fig. 3A, the first source electrode 11 is arranged respectively on the first MOS transistor 21, and the second source electrode 12 is arranged respectively on the first MOS transistor 21. The source electrode 11 and 12 are alternately arranged adjacently to each other. Additionally, electrical isolation is provided between the source electrode 11 and 12. Furthermore, the only one gate pad electrode 25 is arranged for an entirety of the first and second MOS transistor 21 and 22 of the chip.

Fig. 3B shows source electrode in a second layer provided over the first and second source electrode 11 and 12.

When connecting means with external terminals such as a wire bond and a bump electrode is provided, the source electrodes in the second layer are provided as shown in Fig. 3B. A first source electrode 13 in the second layer is provided, for example, as the only one in a plate-like shape as shown in the drawing, and is provided in a manner that it covers a part of the whole plurality of first and second source electrodes 11 and 12 with an insulating film (not illustrated) interposed therebetween. Here, through contact holes (not illustrated) provided in the insulating film, the first source electrode 13 makes contact with the first source electrodes 11 in a first layer.

Similarly, a second source electrode 14 in the second layer is provided as the only one in a plate-like shape in a manner that it covers the rest of the whole plurality of first and second source electrodes 11 and 12 with an insulating film (not illustrated) interposed therebetween. Here, through contact holes (not illustrated) provided in the insulating film, the second source electrode 14 makes contact with the second source electrodes 12 in the first layer.

Fig. 3C is a schematic view of the source electrodes in the first layer in a case where each of the trenches 4 is patterned in stripes on the top surface of the substrate. In line with each adjacent two of the trenches 4, the first and second MOS transistor 21 and 22 are formed as cells, each of which is a stripe. That is, the first and second source electrode 11 and 12 respectively connected to the first and second MOS transistor 21 and 22 are formed in stripes and alternately arranged adjacently to each other. Note that the source electrodes in the second layer are the same as those in Fig. 3B.

As described above, according to the MOSFET 20 of this embodiment, it is possible to realize a switching element capable to operate two MOS transistors by only one gate terminal, and to switch the current path in two directions. Hereinafter, with respect to operations thereof, a description will be given by taking as an example a case where the MOSFET 20 is adopted as a protection circuit.

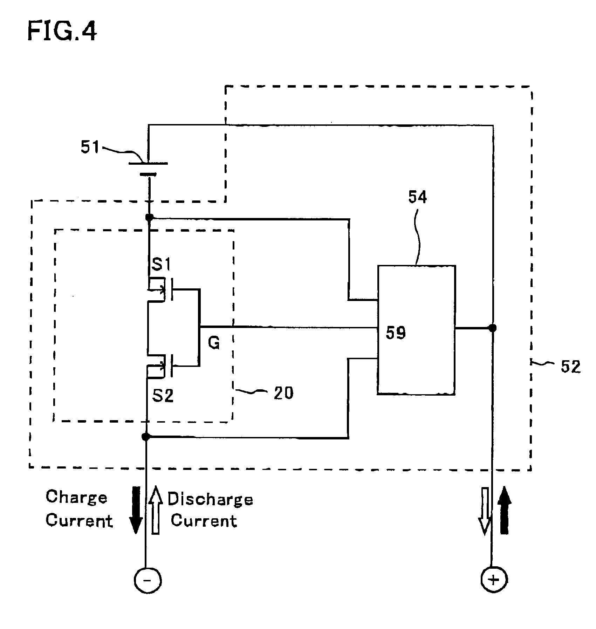

Fig. 4 is a circuit diagram showing a protection circuit for a secondary battery.

A protection circuit 52 is connected in series to a secondary battery 51, and includes MOSFET 20 as a switching element and a control circuit 54. Additionally, one side of the MOSFET 20 toward the first source terminal S1 and the other side thereof toward the second source terminal S2 are set to be a plus terminal (+) and a minus terminal (-) respectively, and a load or a power supply such as an AC adapter is connected therebetween. The MOSFET 20 is the same as that of the first embodiment.

The MOSFET 20 is connected in series to the secondary battery 51 and prevents the secondary battery 51 from being overcharged or overdischarged. That is, a two-way current path is formed in the MOSFET 20.

The control circuit 54 includes only one charge-discharge control terminal 59 which applies a control signal to the gate terminal G of the MOSFET 20.

The control circuit 54, in an charging or discharging operation, turns MOSFET 20 ON, thereby allowing the current to flow in a direction in which the secondary battery 51 charges or in a direction in which it discharges.

Additionally, for example, the control circuit 54 determines a state where a power supply such as an AC adapter is connected between the plus and minus terminals in a overcharged state. Then, the current path is interrupted by turning the MOSFET 20 OFF.

Furthermore, the control circuit 54 determines a state where a load is connected between the plus and minus terminals in a overdischarged state. Then, the current path is interrupted by switching the MOSFET 20 OFF.

These overcharged or overdischarged states can be controlled in such a manner that the control circuit 54 determines a potential of the minus terminal.

That is, during a normal discharging operation, the load is connected between the plus and minus terminals, and the control circuit 54 causes discharging to a predetermined potential. For example, this corresponds to operating on a portable communication device.

Then, in a case where overdischarging occurs in that state, it is required to interrupt the current path. In this case, for example, suppose a potential of the secondary battery 51 to be 1 v and a minus potential thereof to be 0 V.

The control circuit 54 determines a potential of the minus terminal, and if the potential is plus, it judges that it is the state where the load is connected in a overdischarged state. Then, the control circuit 54 turns the MOSFET 20 into an OFF state.

On the other hand, in a case where charging is operated from that state (overdischarged state), the power supply such as an AC adapter may be connected between the plus and minus terminals to allow a current to flow in a direction in which the secondary battery 51 charges. In this case, for example, suppose potentials of the plus terminal and of the minus terminal to be 3 V and -1 V respectively.

The control circuit 54 determines the potential of the minus terminal, and if the potential is minus, it judges that it is the state where the AC adapter is connected in a overdischarged state. Then, the control circuit 54 turns the MOSFET 20 into an ON state. Thus, a current flows in the direction in which the secondary battery 51 charges as shown by arrows denoted as "charging current".

During a normal charging operation, the power supply such as an AC adapter is connected between the plus and minus terminals, the secondary buttery 51 is charged in a way that a charging current is supplied in the direction shown by the arrows.

Then, in a case where overcharging occurs in that state, it is required to interrupt the current path. In this case, for example, suppose potentials of the plus terminal and of the minus terminal to be 4 V and -1 V respectively.

The control circuit 54 determines the potential of the minus terminal, and if the potential is minus, it judges that it is the state where the AC adapter is connected in a overcharged state. Then, the control circuit 54 turns the MOSFET 20 into an OFF state.

On the other hand, in a case where discharging is operated from that state (overcharged state), the load may be connected between the plus and minus terminals to allow a current to flow in a direction in which the secondary battery 51 discharges. In this case, for example, suppose potentials of the plus terminal and of the minus terminal to be 4 V and 1 V respectively.

The control circuit 54 determines the potential of the minus terminal, and if the potential is plus, it judges that it is the state where the load is connected in a overcharged state. Then, the control circuit 54 turns the MOSFET 20 into an ON state. Thus, a current flows in the direction in which the secondary battery 51 discharges as shown by arrows denoted as "discharging current".

Hereinabove, for this embodiment, the description has been given by taking the n-channel MOSFET as an example. However, this embodiment can be similarly applied to a p-channel MOSFET in which a conductivity type is opposite thereto.

According to the embodiment of the present invention, the two MOS transistors to which different source potentials are applied are integrated on one chip. That enables a current to flow along a side wall and a bottoms of each of the trenches. Consequently, even in a case where the chip is mounted by the flip-chip method, it is possible to reduce an increase in resistance in the drain region. Also in a case of the wire bonding method, on-resistance of the device is reduced since the current path between the first MOSFET and the second MOSFET can be shortened.

Additionally, the only one first gate pad electrode is provided in common on the chip. That is, unlike a so-called dual MOSFET where two MOSFETs are integrated, it is possible to enhance a cell density for a portion corresponding to one gate pad electrode. Consequently, on- resistance of the device can also be thus reduced.

Furthermore, a number of external terminals can be three, and thus the number of external terminals is reduced.

## Claims

1. A semiconductor device comprising:
- a semiconductor layer (2) operating as a drain region;
- a first metal-oxide-semiconductor transistor (21) reaching the drain region and comprising a gate electrode (6) and a source region (7) that is formed above the drain region;
- a second metal-oxide-semiconductor transistor (22) reaching the drain region and comprising a gate electrode (6) and a source region (7) that is formed above the drain region;
- a gate terminal (25) connected with the gate of the first transistor and the gate of the second transistor;
- a first source terminal (S1) connected with the source region (7) of the first transistor (21) and receiving a first potential; and
- a second source terminal (52) connected with the source region (7) of the second transistor (22) and receiving a second potential that is different from the first potential.

2. The semiconductor device of claim 1, wherein the first and second transistors (21, 22) are part of a chip, and the gate terminal (25) and the first and second source terminals (S1, S2) are connected with respective leads external to the chip.

3. A semiconductor device comprising:
- a semiconductor substrate (10);
- a semiconductor layer (2) disposed on the semiconductor substrate (1) and operating as a drain region;
- a channel layer (3) disposed on the semiconductor layer (2);
- a plurality of first metal-oxide-semiconductor transistors (21, 22), each of the first transistors (21) comprising a trench (4) penetrating the channel layer (3) and reaching the semiconductor layer (2), a gate electrode (6) disposed in the trench and a source region (7) formed in the channel layer (3); and
- a plurality of second metal-oxide-semiconductor transistors (22), each of the second transistors (22) comprising a trench (4) penetrating the channel layer (3) and reaching the semiconductor layer (2), a gate electrode (6) disposed in the trench (4) and a source region (7) formed in the channel layer (3),
wherein each of the first transistors (21) is adjacent at least one of the second transistors (22), and the source regions (7) of the first transistors (21) are configured to receive a first potential and the source regions (7) of the second transistors (22) are configured to receive a second potential that is different from the first potential.

4. The semiconductor device of claim 3, wherein the first and second transistors (21, 22) are arranged in a grid form so that the first transistors (21) occupy every two grid positions in the grid form.

5. The semiconductor device of claim 3 or 4, further comprising a gate terminal (25) connected with the gate electrodes (6) of the first transistors (21) and the gate electrodes (6) of the second transistors (22).

6. The semiconductor device according to any of claims 3 to 5, the semiconductor layer (2) is configured to allow a current flow between one of the first transistors (21) and one of the second transistors (22) that is adjacent the one of the first transistors (21) through the semiconductor layer (2).
